# EUROPEAN PATENT APPLICATION

(11) **EP 4 823 305 A1**
(43) Date of publication of application: **14.10.2026**
(21) Application number: 25169061.6
(22) Date of filing: 08.04.2025
(51) Int. Cl.: H10N 69/00, H01L 23/00

(54) **FOUNDRY COMPATIBLE, ULTRA-LOW RESISTANCE, UNDER-BUMP-METALLIZATION FOR ELECTROPLATED BUMPS**

(71) Applicant: Imec VZW, 3001 Leuven (BE)
(72) Inventor: Ananthapadmanabha Rao, Vadiraj Manjunath, 9051 Gent (BE); Miller, Robert, 3210 Lubbeek (BE)
(74) Representative: Patent Department IMEC

(57) **Abstract**

A semiconductor structure, comprising: a semiconductor-based substrate; a barrier layer disposed on the substrate; an electroplating seed layer disposed on the barrier layer; wherein the barrier layer is configured for mitigating atom diffusion from the seed layer into the substrate; a capping layer disposed on the seed layer and configured for resisting oxidation of the seed layer; and a solder bump disposed on the capping layer.

## Description

### TECHNICAL FIELD

The present disclosure generally relates to semiconductor processing. Particular embodiments relate to a semiconductor structure, a semiconductor system, and methods for producing the same.

### BACKGROUND

3D heterogeneous integration provides a pathway towards building large-scale integrated systems, for example quantum computers. One of the key requirements for this realization is the development of superconducting bumps that are essential for bonding multiple chips together, routing signals between the chips, and galvanically connecting the different ground planes of the chips to minimize crosstalk. Indium (In), a soft superconducting metal, has been a popular choice for the bump material for cryogenic applications. However, working with In poses some challenges depending on the deposition or growth technique used.

Most demonstrations of In bumps so far have focused on a lift-off technique, where In is evaporated and patterned on an under-bump-metallization (UBM) layer(s) on top of the superconducting material, which comprises the quantum circuit. UBM is required to prevent the formation of intermetallic compounds (IMC) with In and the quantum circuit material. These UBM layer(s), patterned using evaporation and lift-off techniques, also aid with the adhesion of In. The main advantages of the lift-off technique are the ease of fabrication and a variety of material choices that can be experimented with for the UBM layer(s) without worrying about etch selectivity for the different materials.

In semiconductor foundry manufacturing however, lift-off is avoided and subtractive etch (wet/dry) is the preferred method for patterning metal layers. Electrochemical deposition (ECD) is the chosen technique for growing/depositing solder bump material on a seed layer. The seed layer is a low-resistivity material which provides the necessary conduction path for currents in the bumping solder plating process. Typically, in standard semiconductor foundry processing for semiconductor integrated circuits, copper (Cu) is the preferred seed material in the plating process. For superconducting bump applications, electroplated In is the preferred material of choice. However, Cu is a non-superconducting material and is known to form IMC's with In, potentially inducing losses in the bump stack for cryogenic applications, for example superconducting or quantum applications. Plating In, or any other suitable bump material, directly on superconducting materials acting as seed layers, presents another challenge as these superconducting materials are typically very resistive and form a native oxide at room temperature. As a consequence, during the ECD process at room temperature or other known temperatures, this may result in no plating and/or result in non-uniform plating across the wafer.

Rosenberg, D. et al. 3D integrated superconducting qubits. npj Quantum Inf 3, 42 (2017) (hereinafter termed "the MIT approach") describes a UBM comprising Ti(20nm)/Pt(50nm)/Au(100nm) below the In bump. The resistance of the described bump stack is ~240nohm/bump at the operating temperature. The UBM layers and the In bumps are fabricated using evaporation and lift-off.

Yu, J. et al. Indium-Based Flip-Chip Interconnection by Electroplating Method for Superconducting Quantum 3D Integration Architecture. IEEE Electron Device Lett. 45, 2021-2024 (2024) describes electroplated In bumps using Cu as a seed layer. However, the bumps are not superconducting, which suggests that the IMC might have prevented this. This is shown in the critical temperature (Tc) measurement plot in the document. However, the document does not comment on the role of IMC on superconductivity.

### SUMMARY

Building large-scale integrated semiconductor systems, such as for example quantum computers using solid-state qubits, such as superconducting qubits, requires functionalities that may be enabled by heterogeneous 3D integration used in present-day computing devices. One of the key elements necessary for such scaling route is the development of superconducting bumps, which are used for galvanically connecting the different dies in the 3D stack. In advanced foundry semiconductor manufacturing processes that employ for example thermal-compression bonding techniques, ECD, for example electroplating is the preferred growth method for bumps. The electroplating or plating process may require a seed material, typically a low resistance material such as copper (Cu), which provides a high-conductance path, during processing, for the plating currents thus ensuring uniform bump plating across the wafer. In the case of indium (In), a superconducting soft metal, it is well known that it forms an intermetallic compound (IMC) with Cu. This formed IMC interface may add losses in the bump, thereby limiting the current-carrying capacity of the bump and causing for example qubit decoherence in an exemplary quantum computing device. It is an objective of the present disclosure to provide an under-bump-metallization layer in a semiconductor foundry-compatible setting, that allows to produce ultra-low resistance, IMC-free, uniform bumps across a semiconductor wafer, for example a 300mm wafer. The ultra-low resistance is to be obtained at cryogenic or superconducting operating conditions which may be different from the processing conditions for the UBM. It is noted that embodiments according to the present disclosure are not necessarily limited to superconducting quantum applications. Certain exemplary embodiments according to the present disclosure avoid the IMC formation by introducing a capping material on top of the seed layer, over which the bump can be electroplated without compromising the required high conductance and uniformity of the plating process. Certain exemplary embodiments according to the present disclosure also have the potential to proximitize the seed layer and ensure a fully superconducting bump stack, despite the seed material being a non-superconductor. This integration structure can be adopted in a semiconductor foundry-compatible process flow to produce ultra-low resistance (potentially superconducting) UBM and associated bumps for quantum computing and/or other cryogenic applications.

Differently from the prior art "MIT approach" described above, certain exemplary embodiments according to the present disclosure may use sputtered materials for the UBM and the In may be electroplated using a resist mask. The UBM layers may be etched using subtractive techniques.

It is an aim for embodiments according to the present disclosure to address at least some of the above-described problems.

Accordingly, there is provided in a first aspect of the present disclosure a semiconductor structure, comprising:
- a semiconductor-based substrate;
- a barrier layer disposed on the substrate;
- a seed layer disposed on the barrier layer;
wherein the barrier layer is configured for mitigating atom diffusion from the seed layer into the substrate;
- a capping layer disposed on the seed layer and configured for resisting oxidation of the seed layer; and
- a solder bump disposed on the capping layer.

The present solution may help to improve wafer uniformity of the bumps from centre to edge of the wafer, without forming IMCs between seed and bump material.

The barrier layer may serve to protect the semiconductor-based substrate, which may for example comprise a semiconductor circuit, in particular a quantum circuit, against further processing steps. Moreover, the barrier layer may improve seed layer adhesion compared to the seed layer directly on the substrate.

It is noted that the solder bump may also be termed an electrode, in the sense that the solder bump is the part of the structure to which it is intended to couple an external conductor for example present on another die in an heterogenous system.

The substrate may preferably be a semiconductor substrate, for example a Si substrate, or a substrate on top of which a quantum circuit is disposed.

The substrate may preferably comprise a conductive pattern, using a material configured for being superconducting under a critical temperature threshold, thus achieving superconductivity in operation.

The capping layer may preferably be deposited in situ.

The capping layer may also serve to mitigate or even completely prevent IMC from forming during processing and/or bonding.

It is noted that the expression "A disposed on B" may be taken to mean that A is placed atop on and in physical contact with B.

In an embodiment, the barrier layer is made of a material configured for being superconducting under a critical temperature threshold.

In an embodiment, the capping layer is made of a material configured for being superconducting under a critical temperature threshold.

In an embodiment, the capping layer is made of an oxidation-resistant material.

In an embodiment, the seed layer is made of a metal material having a sheet resistance lower than 0.3 Ohm/sq at room temperature or any suitable temperature in the plating process.

The physical parameter "sheet resistance" does not have standardized SI units, but academia and industry use Ohm/sq as a well-accepted unit.

In an embodiment, the seed layer comprises any one or more of the following materials: Cu; Al; Ag; Ru; and Mo.

If the seed layer is made of a pure element, it features improved conduction compared to alloys. Alloys of the mentioned materials are also possible and included in the scope of the embodiment by the phrasing made of.

Some of the listed materials (e.g. Cu and Ag) are not superconducting materials. However, in certain superconducting settings, this may be acceptable because they feature a sufficiently low electrical resistance.

In an embodiment, the barrier layer comprises any one or more of the following materials TiN and TaN.

In an embodiment, the solder bump is made of a material configured for being superconducting under a critical temperature threshold, and wherein the solder bump is preferably made of In or an InSn alloy.

The solder bump may preferably be made of In because In is a material configured for being superconducting under a critical temperature threshold. Furthermore, In is also a good soldering material.

In an embodiment, the capping layer comprises any one or more of the following materials: TiN; TaN; and Ru.

In an embodiment, the barrier layer has a thickness within a range of 50-100 nm; and/or the seed layer has a thickness within a range of 25-100 nm; and/or the capping layer has a thickness within a range of 10-50 nm; and/or the solder bump has a thickness within a range of 5-15 um; wherein each thickness of said thicknesses is measured in a direction extending from the solder bump to a portion of the substrate closest to the solder bump.

In second aspect of the present disclosure, there is provided a semiconductor system comprising:
- a first semiconductor structure according to any one preceding claim; and
- a second semiconductor structure according to any one preceding claim;

wherein the solder bump of the first semiconductor structure also serves as the solder bump of the second semiconductor structure; and
wherein the first semiconductor structure and the second semiconductor structure are preferably arranged diametrically opposed to each other from the perspective of their shared solder bump.

It should be clear that after bonding the first and second semiconductor structures, a semiconductor system is formed wherein the solder bumps of both semiconductor structures can be seen as a single solder bump. So, the solder bumps of both semiconductor structures serve a common purpose and can be seen as 1 solder bump. The claim scope is to include the case where both semiconductor structures have prior to bonding each their own solder bump that are joined to a single solder bump after bonding. The scope also includes the case where only one of the semiconductor structures to be bonded has a solder bump according to the first aspect of the invention. The second semiconductor structure does not have a solder bump prior to bonding. However, after bonding the second semiconductor structure does fall under the scope of the first aspect of the invention. As the solder bump of the opposing semiconductor structure is now the common solder bump, as in the second aspect of the invention. The semiconductor not having a solder bump prior to bonding, does require a barrier, seed and capping layer prior to bonding, to ensure the features of the claim corresponding to the second embodiment are met.

In third aspect of the present disclosure, there is provided a method for producing a semiconductor structure; the method comprising:
- providing a semiconductor-based substrate;
- forming a barrier layer on the substrate, wherein the barrier layer is configured for blocking atom diffusion from the seed layer into the substrate;
- forming a seed layer on the barrier layer;
- forming a capping layer on the seed layer, wherein the capping layer is configured for resisting oxidation of the seed layer; and
- forming a solder bump on the capping layer.

In an embodiment, the method comprises removing any oxidation from the capping layer prior to the step of forming the solder bump.

In fourth aspect of the present disclosure, there is provided a method for producing a semiconductor system; the method comprising:
- producing a first semiconductor structure according to any one of claims 12-13; and
- producing a second semiconductor structure according to any one of claims 12-13;
wherein the solder bump of the first semiconductor structure also serves as the solder bump of the second semiconductor structure; and wherein the first semiconductor structure and the second semiconductor structure are preferably arranged diametrically opposed to each other from the perspective of their shared solder bump. The method according to the fourth aspect covers the case where both the semiconductors have solder bumps prior to bonding and further also covers the case where only one semiconductor has a solder bump prior to bonding whereas the other has not. In the latter case the forming of the solder bump on the capping layer of the third embodiment, can be seen as the bonding process. As a result thereof the solder bump of the first semiconductor, which is present prior to bonding and made during the providing step of the first semiconductor, can be seen as serving as a solder bump of the second semiconductor structure. The claims scope related to the fourth aspect therefor covers both cases.

It will be understood by the skilled person that various specific features, advantages, and technical considerations applying to the above-described embodiments of the electronic structure according to the present disclosure may also apply to embodiments of the method, *mutatis mutandis.* In particular, any structure embodiment described above or below in the present disclosure will be understood by the skilled person to have or potentially have a corresponding method embodiment, and *vice versa.*

### BRIEF DESCRIPTION OF THE DRAWINGS

The above-described embodiments present the invention in an illustrative and nonlimiting manner. The invention will be more fully understood by the skilled person with the help of the accompanying drawings, in which:
Figure 1 shows a prior art bump cross-section diagram wherein the bump material (In) is plated on a seed layer (Cu) which forms an IMC. The solder bump is consumed due to the IMC formations which shrinks its lateral dimensions.
Figure 2 illustrates certain exemplary embodiments of the semiconductor structure according to the present disclosure.
Figure 3 illustrates certain exemplary embodiments according to the present disclosure, showing the integration of the bump on top of a superconducting material according to the third aspect of the invention.
Figure 4 illustrates two exemplary embodiments according to the present disclosure, showing a method for producing a semiconductor structure according to the disclosure.

### DETAILED DESCRIPTION

It will be understood that all of the following detailed description is intended as an illustrative example only, and that the scope of the present invention is to be determined by the appended claims.

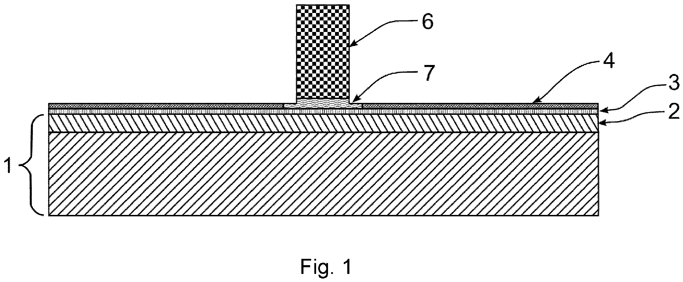

Figure 1 shows a prior art bump cross-section diagram wherein the bump material (6) (In) is plated on a seed layer (4) (Cu) which thereby forms an IMC (7). This IMC could result in added loss in the bump stack which could limit the current carrying capacity of the bump when used to connect signal lines in quantum circuits.

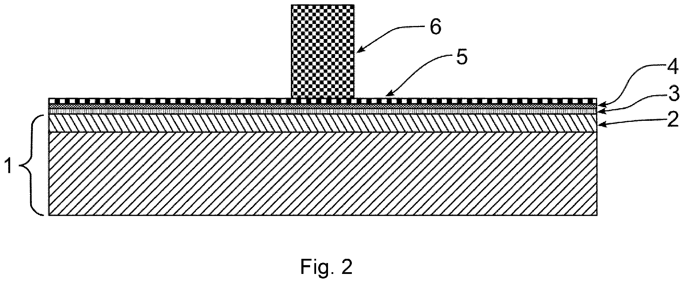

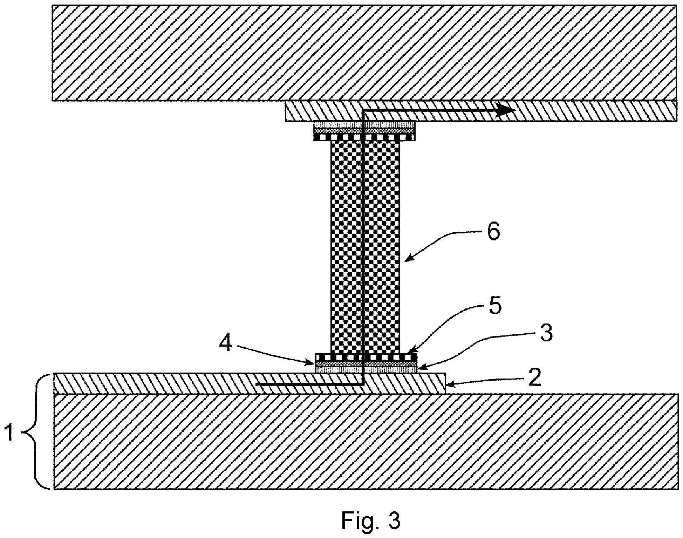

To alleviate this issue, exemplary embodiments according to the present disclosure feature a (preferably superconducting) capping material (5) (see Figure 2), which prevents the formation of the IMC (7) between the (In) bump material (6) and the seed layer (4) (Cu). The capping layer (5) does not compromise the required high conductivity for bump plating as the resistance of the capping layer (5) is in parallel to that of the seed layer (4). The conductivity of this tri-layer stack is still dominated by the seed layer (4), thus ensuring uniformity of the electroplating process. A situation is shown in Fig 3, where two quantum chips are bonded together using the bump and the path of the superconducting path is indicated by an arrow.

Figure 1 shows prior art bumps directly on top of seed layer (4). IMC (7) formation of bump with seed material is shown. This could result in a lossy interface in the bump stack.

Figure 2 illustrates certain embodiments according to the present disclosure introduce a highly conductive capping material (5) (preferably superconducting) which prevents IMC formation and also serves to proximitize the seed material.

Figure 3 shows a cross-section of a device with bumps fabricated using the proposed invention on top of a suitable superconducting material. The bump is part of a signal line connecting the bottom and the top structures according to second aspect of the disclosure. This signal path is ultra-low resistance (potentially superconducting) during operation.

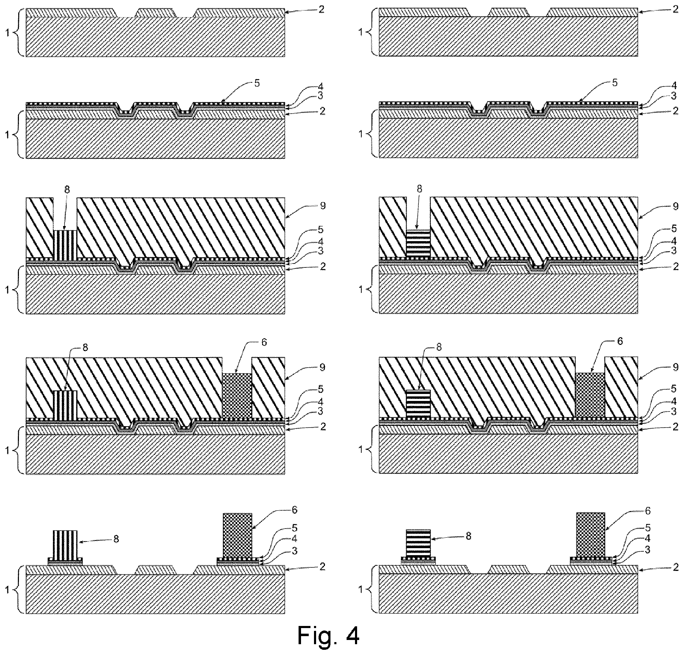

In other words, Figure 3 illustrates certain exemplary embodiments according to the second aspect of the present disclosure, showing the integration of the bump on top of a superconducting material which forms the semiconductor system. Two semiconductor structures, dies, chips or equivalents (bottom and top), each may have superconducting circuits, for example quantum circuits, are bonded together using the bump fabrication process as claimed and depicted in Figure 4. The cap (5), seed (4) and barrier (3) materials are selectively etched with respect to the other circuit material after the electroplating process.

One of the advantages of solutions according to the present disclosure, is the potential for using proximity induced superconductivity effects. By choosing appropriate superconducting materials for the barrier and capping layers, it might be possible to proximitize the seed layer (4). In doing so, one can obtain fully superconducting bump connections, despite the seed layer (4) may be a non-super conducting metal. Enabling this functionality will make integration of such a device simpler, without introducing potential lossy interfaces, such as the IMC (7).

Examples of the different layers and their respective functions/properties are mentioned in the following. Materials may be chosen accordingly.

The barrier layer (3) may act as a barrier layer between the seed layer and the substrate (1). The substrate may further comprise a circuit (2) which may be a superconducting-, cryogenic- or quantum-circuit. Therefore, the barrier layer (3) may also protect any potentially present circuit (2), which is as said part of the substrate (1), during further processing. The barrier layer (3) may also serve as an adhesion layer for the seed layer to the substrate. The barrier layer is in between the outer layer of the substrate (1) which may be the outer layer of the circuit (2) if present, and the seed layer (4).

Ideally, the barrier layer is superconducting with a high Tc, features good adhesion to Si, and/or can be selectively etched to the exposed materials.

The barrier layer may comprise TiN or TaN, Alternatively the barrier layer may comprise a layered combination of TiN and TaN. The skilled person will recognize that other materials or sandwiches thereof that is/are configured for mitigating atom diffusion from the seed layer (4) into the substrate are possible and included in the scope of the independent claim.

The seed layer (4) may be used for the ECD, ie electroplating process, and/or may help to ensure uniformity of the plating.

Ideally, the seed layer features high conductivity, can be a superconductor (Ruthenium noted as Ru), with comparable resistivity to Cu at room temperature, features good adhesion to the barrier layer, can be preferably deposited *in situ* with the barrier layer, is thin enough for uniform plating, and/or can be selectively etched to the barrier layer and other exposed materials during the etching process..

The capping layer (5) may help to minimize or fully prevent the formation of IMC (7) between the bump (6) and the seed layer (4).

Ideally, the capping layer is superconducting and preferably has a high Tc, is native-oxide free, can be plated with a bump material (In), does not form an IMC (7) with the bump material (In), is thin, can be preferably deposited *in situ* with the barrier layer (3) and the seed layer, and/or can be selectively etched to the seed and any other exposed material during the etch.

## Claims

1. A semiconductor structure, comprising:
- a semiconductor-based substrate (1);
- a barrier layer (3) disposed on the substrate (1);
- an seed layer (4) disposed on the barrier layer (3);
wherein the barrier layer (3) is configured for mitigating atom diffusion from the seed layer (4) into the substrate (1);
- a capping layer (5) disposed on the seed layer (4) and configured for resisting oxidation of the seed layer (4); and
- a solder bump (6) disposed on the capping layer (5).

2. The semiconductor structure of claim 1, wherein the barrier layer (3) is made of a material configured for being superconducting under a critical temperature threshold.

3. The semiconductor structure of any one preceding claim, wherein the capping layer (5) is made of a material configured for being superconducting under a critical temperature threshold.

4. The semiconductor structure of any one preceding claim, wherein the capping layer (5) is made of an oxidation-resistant material.

5. The semiconductor structure of any one preceding claim, wherein the seed layer (4) is made of a metal material having a sheet resistance lower than 0.3 Ohm/sq.

6. The semiconductor structure of any one preceding claim, wherein the seed layer (4) comprises any one or more of the following materials Cu; Al; Ag; Ru; and Mo.

7. The semiconductor structure of any one preceding claim, wherein the barrier layer (3) comprises any one or more of the following materials: TiN and TaN.

8. The semiconductor structure of any one preceding claim, wherein the capping layer (5) comprises any one or more of the following materials: TiN; TaN; and Ru.

9. The semiconductor structure of any one preceding claim, wherein the solder bump (6) is made of a material configured for being superconducting under a critical temperature threshold, and wherein the solder bump (6) is preferably made of In or an InSn alloy.

10. The semiconductor structure of any one preceding claim, wherein:
- the barrier layer (3) has a thickness within a range of 50-100 nm; and/or
- the seed layer (4) has a thickness within a range of 50-100 nm; and/or
- the capping layer (5) has a thickness within a range of 25-50 nm; and/or
- the solder bump (6) has a thickness within a range of 5-15 µm;
wherein each thickness of said thicknesses is measured in a direction extending from the solder bump (6) to a portion of the substrate (1) closest to the solder bump.

11. A semiconductor system comprising:
- a first semiconductor structure according to any one preceding claim; and
- a second semiconductor structure according to any one preceding claim;
wherein the solder bump of the first semiconductor structure also serves as the solder bump (6) of the second semiconductor structure; and
wherein the first semiconductor structure and the second semiconductor structure are preferably arranged diametrically opposed to each other from the perspective of their shared solder bump.

12. A method for producing a semiconductor structure; the method comprising:
- providing a semiconductor-based substrate (1);
- forming a barrier layer (3) on the substrate, wherein the barrier layer (3) is configured for blocking atom diffusion from the seed layer (4) into the substrate;
- forming a seed layer (4) on the barrier layer;
- forming a capping layer (5) on the seed layer, wherein the capping layer (5) is configured for resisting oxidation of the seed layer (4); and
- forming a solder bump (6) on the capping layer.

13. The method of claim 12, comprising removing any oxidation from the capping layer (5) prior to the step of forming the solder bump (6).

14. A method for producing a semiconductor system; the method comprising:
- producing a first semiconductor structure using the method of claim 12 or 13; and
- producing a second semiconductor structure using the method of claim 12 or 13;
wherein the solder bump (6) of the first semiconductor structure also serves as the solder bump of the second semiconductor structure; and
wherein the first semiconductor structure and the second semiconductor structure are preferably arranged diametrically opposed to each other from the perspective of their shared solder bump.
